# EUROPEAN PATENT APPLICATION

(11) **EP 4 429 137 A1**
(43) Date of publication of application: **11.09.2024**
(21) Application number: 22900235.7
(22) Date of filing: 09.11.2022
(51) Int. Cl.: H04L 1/00

(54) **DATA PACKET PROCESSING METHOD, COMMUNICATION APPARATUS AND COMMUNICATION SYSTEM**

(30) Priority: 30.11.2021 CN 202111450373
(71) Applicant: Huawei Technologies Co., Ltd., Shenzhen, Guangdong 518129 (CN)
(72) Inventor: CHENG, Hao, Shenzhen, Guangdong 518129 (CN)
(74) Representative: Pfenning, Meinig & Partner mbB
(86) International application number: PCT/CN2022/130825
(87) International publication number: WO 2023/098430

(57) **Abstract**

Embodiments of this application provide a data packet processing method, a communication apparatus, and a communication system. The method includes: receiving a data packet from a first device; checking the data packet based on first CRC in the data packet; checking a packet header of the data packet based on second CRC in the data packet; and if check on the data packet fails and check on the packet header fails, discarding the data packet; or if check on the data packet fails but check on the packet header succeeds, processing the data packet based on a type of the data packet. In this solution, the data packet carries the first CRC used to check the data packet and the second CRC used to check the packet header of the data packet. When check on the data packet fails but check on the packet header succeeds, it indicates that the packet header is correctly transmitted, but data is incorrectly transmitted. In this case, a second device may process the data packet based on the type of the data packet, instead of directly discarding the data packet. In this way, a quantity of packet losses can be reduced, thereby improving data transmission efficiency and increasing a system capacity.

## Description

### CROSS-REFERENCE TO RELATED APPLICATIONS

This application claims priority to Chinese Patent Application No. 202111450373.5, filed with the China National Intellectual Property Administration on November 30, 2021 and entitled "DATA PACKET PROCESSING METHOD, COMMUNICATION APPARATUS, AND COMMUNICATION SYSTEM", which is incorporated herein by reference in its entirety.

### TECHNICAL FIELD

This application relates to the field of communication technologies, and in particular, to a data packet processing method, a communication apparatus, and a communication system.

### BACKGROUND

When devices communicate with each other, data needs to be received and sent between the devices. For example, a first device sends data to a second device; or a second device sends data to a first device.

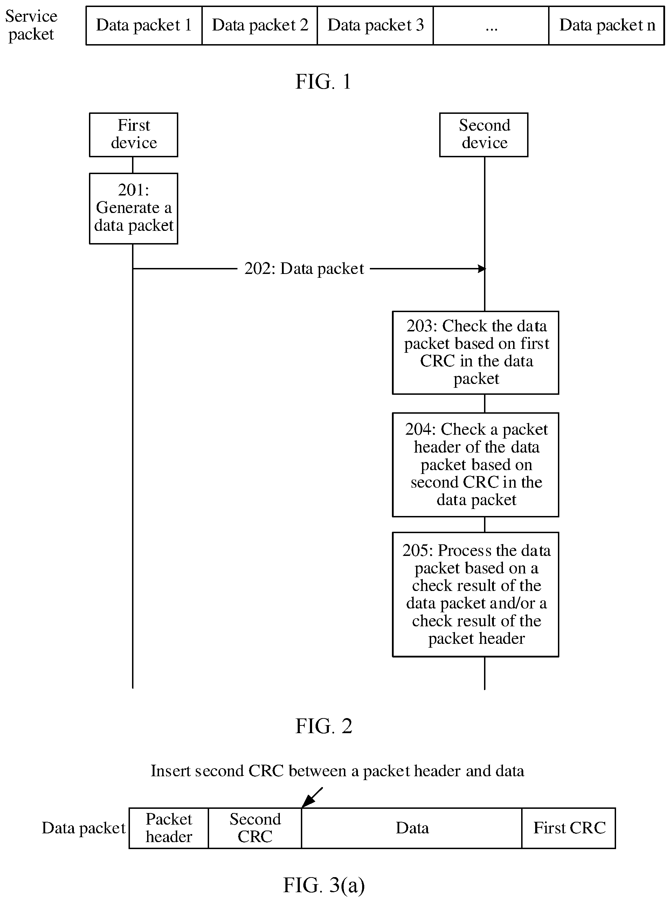

To increase a data sending rate, one service packet is generally split into a plurality of data packets for sending, and then a receiver assembles the received plurality of data packets to obtain the complete service packet. FIG. 1 is an example diagram of a service packet. One service packet is split into n data packets and sent sequentially, where n is an integer greater than 1.

To ensure accuracy of data receiving, the receiver needs to check each data packet after receiving the data packet. When check on one data packet fails, it indicates that an error occurs in a sending process of the data packet. Generally, the data packet on which check fails is directly discarded.

### SUMMARY

Embodiments of this application provide a data packet processing method, a communication apparatus, and a communication system, to improve data transmission efficiency and increase a system capacity.

According to a first aspect, an embodiment of this application provides a data packet processing method. The method may be performed by a second device or a module (for example, a chip) used in the second device. The method includes: receiving a data packet from a first device, where the data packet includes a packet header, data, first cyclic redundancy check (Cyclic Redundancy Check, CRC), and second CRC; checking the data packet based on the first CRC in the data packet; checking the packet header of the data packet based on the second CRC in the data packet; and processing the data packet based on a check result of the data packet and/or a check result of the packet header.

In a possible implementation, the processing the data packet based on a check result of the data packet and/or a check result of the packet header includes: if check on the data packet succeeds, or if check on the data packet succeeds and check on the packet header succeeds, skipping discarding the data packet; if check on the data packet fails and check on the packet header fails, discarding the data packet; or if check on the data packet fails but check on the packet header succeeds, processing the data packet based on a type of the data packet.

According to the foregoing solution, the data packet carries the first CRC used to check the data packet and the second CRC used to check the packet header of the data packet. When check on the data packet fails but check on the packet header succeeds, it indicates that the packet header is correctly transmitted, but the data is incorrectly transmitted. In this case, the second device may process the data packet based on the type of the data packet, instead of directly discarding the data packet. In this way, a quantity of packet losses can be reduced, thereby improving data transmission efficiency and increasing a system capacity.

In a possible implementation, the checking the packet header of the data packet based on the second CRC in the data packet may be: if check on the data packet fails, checking the packet header of the data packet based on the second CRC in the data packet. If check on the data packet fails, it indicates that an error occurs during transmission of the data packet. In this way, the packet header of the data packet is further checked based on the second CRC in the data packet, to determine whether an error occurs in the packet header. If check on the data packet succeeds, it indicates that no error occurs during transmission of the data packet. In this case, the packet header of the data packet does not need to be checked based on the second CRC, to reduce a quantity of check times and improve a check speed.

In a possible implementation, if check on the data packet fails, the data packet is marked. In other words, if check on the data packet fails, the data packet is not discarded. Instead, the data packet is marked. For example, the data packet may be marked by using a special character or a specific bit (or a bit location), to indicate that the data packet is a data packet that needs to be further determined. Subsequently, the packet header of the data packet is checked by using the second CRC again, and whether to discard the data packet or not to discard the data packet is determined based on the check result of the second CRC. The mark may also indicate or prompt a module or a device that performs next processing on the data packet that there is an error in the data in the data packet.

In a possible implementation, the processing the data packet based on the type of the data packet may be: if the type of the data packet is user plane data, skipping discarding the data packet; or if the type of the data packet is control plane data, discarding the data packet.

According to the foregoing solution, if the type of the data packet is the user plane data, it means that the packet header of the data packet is correctly transmitted, a transmission error occurs in the data in the data packet, and the data is the user plane data. In this case, although some errors occur in the transmitted user plane data, the user plane data can be correctly processed because the packet header is correctly transmitted. In addition, the error in the user plane data may slightly affect user experience, and actually does not cause other more serious impact. Therefore, the second device may not discard the data packet. This manner can improve data transmission efficiency and increase a system capacity. If the type of the data packet is the control plane data, it means that the packet header of the data packet is correctly transmitted, a transmission error occurs in the data in the data packet, and the data is the control plane data. In this case, although the packet header is correctly transmitted, an error occurs in the transmitted control plane data. Because a consequence caused by the error in the control plane data is relatively serious, the second device discards the data packet.

In a possible implementation, before the data packet is processed based on the type of the data packet, the type of the data packet is first determined based on the packet header.

In a possible implementation, if determining not to discard the data packet, the second device may further delete the second CRC from the data packet.

According to the foregoing manner, deleting the second CRC from the data packet can simplify a subsequent processing procedure or reduce complexity, reduce modifications to a processing module, and reduce an amount of data that needs to be transmitted inside the second device or an amount of data that needs to be transmitted by the second device to another device or module.

In a possible implementation, the first CRC is located at a tail of the data packet, and the second CRC is located after the packet header of the data packet.

In a possible implementation, the first CRC is generated based on the packet header of the data packet, the data in the data packet, and the second CRC. Alternatively, the first CRC is generated based on the packet header of the data packet and the data in the data packet.

In a possible implementation, the second CRC is generated based on the packet header of the data packet.

In this solution, because the second CRC is generated based on the packet header, the second CRC may be used to check transmission correctness of the packet header, so that correct transmission of the packet header can be ensured.

In a possible implementation, the second CRC is generated based on the packet header of the data packet and a part of the data in the data packet.

In this solution, the second CRC may be inserted at a fixed length location after a start location of the data packet. Therefore, the second CRC may divide the original data into a first data part that is located before the second CRC and a second data part that is located after the second CRC. In this case, the second CRC may be generated based on the packet header and the first data part that are located before the second CRC. In one aspect, because the second CRC is generated based on the packet header and the part of data, the second CRC may be used to check transmission correctness of the packet header, so that correct transmission of the data packet can be ensured. In another aspect, because the second CRC is inserted at the fixed location after the start location of the data packet, a manner for generating and inserting the second CRC can be simplified, thereby improving a data packet generation speed.

In a possible implementation, the data packet is an enhanced common public radio interface (enhanced common public radio interface, eCPRI) data packet, and the data in the data packet includes eCPRI data.

According to a second aspect, an embodiment of this application provides a data packet processing method. The method may be performed by a first device or a module (for example, a chip) used in the first device. The method includes: generating a data packet, where the data packet includes a packet header, data, first CRC, and second CRC, the first CRC is used to check the data packet, and the second CRC is used to check the packet header; and sending the data packet to a second device.

According to the foregoing solution, the data packet carries the first CRC used to check the data packet and the second CRC used to check the packet header of the data packet. Therefore, after receiving the data packet, the second device may determine, based on the first CRC and the second CRC, a manner for processing the data packet.

In a possible implementation, the second CRC is generated based on the packet header.

In this solution, because the second CRC is generated based on the packet header, the second CRC may be used to check transmission correctness of the packet header, so that correct transmission of the packet header can be ensured.

In a possible implementation, the generating the second CRC based on the packet header may be specifically: generating the second CRC based on the packet header and a part of the data.

In this solution, the second CRC may be inserted at a fixed length location after a start location of the data packet. Therefore, the second CRC may divide the original data into a first data part that is located before the second CRC and a second data part that is located after the second CRC. In this case, the second CRC may be generated based on the packet header and the first data part that are located before the second CRC. In one aspect, because the second CRC is generated based on the packet header and the part of data, the second CRC may be used to check transmission correctness of the packet header, so that correct transmission of the packet header can be ensured. In another aspect, because the second CRC is inserted at the fixed location after the start location of the data packet, a manner for generating and inserting the second CRC can be simplified, thereby improving a data packet generation speed.

In a possible implementation, the first CRC is generated based on the packet header and the data.

In a possible implementation, the first CRC is generated based on the packet header, the data, and the second CRC.

In this solution, because the first CRC is generated based on the packet header, the data, and the second CRC, the first CRC may be used to check transmission correctness of the data packet, so that correct transmission of the packet header can be ensured.

In a possible implementation, the first CRC is located at a tail of the data packet, and the second CRC is located after the packet header of the data packet.

In a possible implementation, the data packet is an eCPRI data packet, and the data in the data packet includes eCPRI data.

In a possible implementation, the packet header indicates a type of the data packet, and the type of the data packet is user plane data or control plane data.

According to a third aspect, an embodiment of this application provides a communication apparatus. The apparatus may be a second device or a module (for example, a chip) used in the second device. The apparatus has a function of implementing any implementation of the first aspect. The function may be implemented by using hardware, or may be implemented by hardware executing corresponding software. The hardware or the software includes one or more modules corresponding to the foregoing function.

According to a fourth aspect, an embodiment of this application provides a communication apparatus. The apparatus may be a first device or a module (for example, a chip) used in the first device. The apparatus has a function of implementing any implementation of the second aspect. The function may be implemented by using hardware, or may be implemented by hardware executing corresponding software. The hardware or the software includes one or more modules corresponding to the foregoing function.

According to a fifth aspect, an embodiment of this application provides a communication apparatus, including at least one processor, where the at least one processor is configured to be coupled to a memory, and read and execute instructions in the memory, to implement any implementation in the first aspect and the second aspect. The memory may be located inside or outside the apparatus.

According to a sixth aspect, an embodiment of this application provides a communication apparatus, including a processor and a memory. The memory is configured to store computer instructions. When the apparatus is run, the processor executes the computer instructions stored in the memory, so that the apparatus performs any implementation in the first aspect and the second aspect.

According to a seventh aspect, an embodiment of this application provides a communication apparatus, including units or means (means) configured to perform steps of any implementation in the first aspect and the second aspect.

According to an eighth aspect, an embodiment of this application provides a communication apparatus, including a processor and an interface circuit. The processor is configured to: communicate with another apparatus through the interface circuit, and perform any implementation in the first aspect and the second aspect. There are one or more processors.

According to a ninth aspect, an embodiment of this application further provides a computer program product. The computer program product includes a computer program or instructions. When the computer program or the instructions are run by a communication apparatus, any implementation in the first aspect and the second aspect is performed.

According to a tenth aspect, an embodiment of this application further provides a computer-readable storage medium. The computer-readable storage medium stores instructions, and when the instructions are run on a communication apparatus, any implementation in the first aspect and the second aspect is performed.

According to an eleventh aspect, an embodiment of this application further provides a chip system, including: a processor, configured to perform any implementation in the first aspect and the second aspect.

According to a twelfth aspect, an embodiment of this application further provides a communication system, including: a second device, configured to perform any implementation in the first aspect, and a first device, configured to perform any implementation in the second aspect.

### BRIEF DESCRIPTION OF DRAWINGS

FIG. 1 is an example diagram of a service packet;
FIG. 2 is a schematic flowchart of a data packet processing method according to an embodiment of this application;
FIG. 3(a) is a schematic diagram of a data packet format according to an embodiment of this application;
FIG. 3(b) is another schematic diagram of a data packet format according to an embodiment of this application;
FIG. 4(a) is an example diagram of an existing eCPRI-based service packet;
FIG. 4(b) is a schematic diagram of inserting CRC into a service data packet according to an embodiment of this application;
FIG. 5 is a schematic diagram of structures of a first device and a second device according to an embodiment of this application;
FIG. 6 is a schematic diagram of a communication apparatus according to an embodiment of this application; and
FIG. 7 is a schematic diagram of a communication apparatus according to an embodiment of this application.

### DESCRIPTION OF EMBODIMENTS

FIG. 2 is a schematic flowchart of a data packet processing method according to an embodiment of this application. In this embodiment, a first device serves as a sender, and a second device serves as a receiver. Certainly, the method is also applicable to a case in which the second device serves as a sender, and the first device serves a receiver. For example, the first device may be a communication device or a functional module, such as a baseband unit (baseband unit, BBU), a central unit (Central Unit, CU), or a distributed unit (Distributed Unit, DU), that has a baseband signal processing function. The second device is a radio unit (radio unit, RU), and the RU herein may be, for example, a communication device or a functional module, such as a radio remote unit (radio remote unit, RRU) or an adaptive antenna unit (adaptive antenna unit, AAU), that has a function of processing an intermediate frequency signal, a radio frequency signal, or an intermediate radio frequency signal. Alternatively, the first device is an RU, and the second device is a BBU. An interface between the first device and the second device may be an eCPRI or another type of interface. This is not limited in this embodiment of this application.

The method includes the following steps.

Step 201: The first device generates a data packet, where the data packet includes a packet header, data, first CRC, and second CRC.

The first CRC is used to check the data packet. Optionally, the first device may generate the first CRC based on the packet header and the data, or the first device generates the first CRC based on the packet header, the data, and the second CRC.

The second CRC is used to check the packet header. Optionally, the first device generates the second CRC based on the packet header, or the first device generates the second CRC based on the packet header and a part of the data.

The packet header of the data packet indicates a type of the data packet, and the type of the data packet is user plane data or control plane data. That the type of the data packet is user plane data means that all of the data in the data packet is user plane data, or includes user plane data and other data. That the type of the data packet is control plane data means that all of the data in the data packet is control plane data, or includes control plane data and other data. Optionally, if the data packet includes control plane data, the type of the data packet is control plane data. The type of the data packet may also be understood as a type of the data in the data packet.

The user plane data refers to actual service data, for example, voice data or packet service data. The control plane data refers to a control message or signaling, for example, a cell setup message, a cell release message, or a message related to operation and maintenance.

A packet assembly form of the data packet is not limited in this embodiment of this application. To be specific, a location relationship between the packet header, the data, the first CRC, and the second CRC in the data packet is not limited. For example, the first CRC is located at a tail of the data packet, and the second CRC is located after the packet header of the data packet. For another example, the first CRC is located at a tail of the data packet, and the second CRC is located between the packet header and the data.

Optionally, the data in the data packet includes key information (for example, information that affects a data packet processing manner) that needs to be protected and service data. The key information herein includes, for example, an eCPRI type. In this case, the second CRC may be inserted after the packet header and the key information, and is generated based on the packet header and the key information, so that correct transmission of the key information can be ensured by using the second CRC. For example, the data in the data packet includes the eCPRI type and eCPRI data. In this case, the second CRC may be inserted at a location after the eCPRI type.

The following describes, with reference to the accompanying drawings, the assembly form of the data packet by using an example.

FIG. 3(a) is a schematic diagram of a data packet format. The second CRC is located between the packet header and the data. Specifically, the second CRC is located after the packet header and before the data. The first CRC is located at the tail of the data packet. The second CRC is generated based on the packet header. The first CRC is generated based on the packet header and the data, or is generated based on the packet header, the second CRC, and the data. It should be noted that, for different data packets, packet header sizes may be different. Therefore, distances between start locations of second CRC and start locations of packet headers in different data packets may be different. Based on this implementation, the packet header size may be learned in advance, so that the second CRC can be inserted after the packet header based on the packet header size.

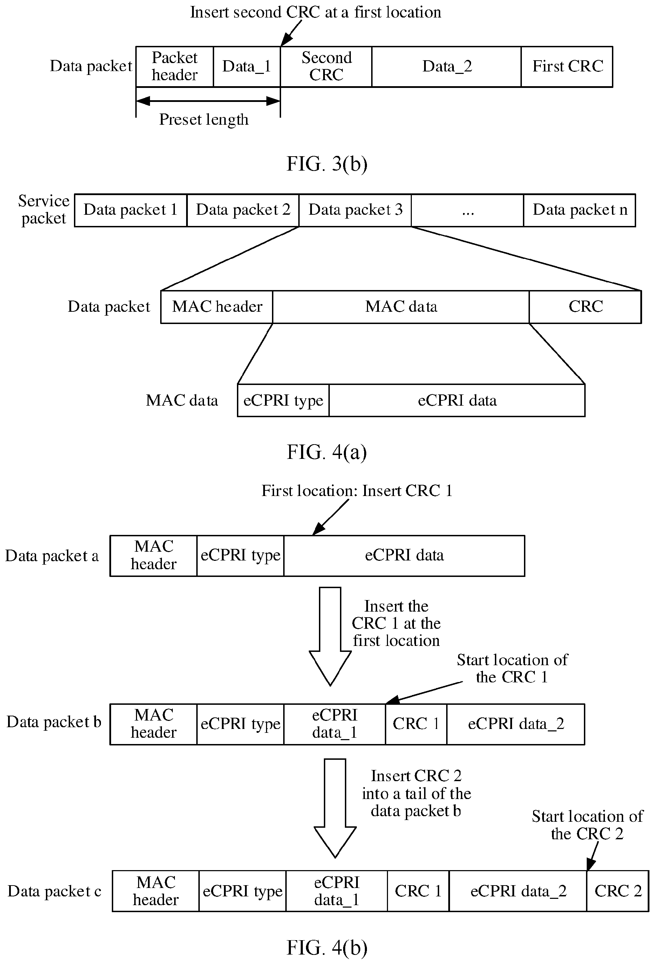

FIG. 3(b) is another schematic diagram of a data packet format. The second CRC is located in the data. After the second CRC is inserted, the original data is divided into two parts by the second CRC. The data part before the second CRC is referred to as data_1, and the data part after the second CRC is referred to as data_2. A combination of data_1 and data_2 is the original data. The first CRC is located at the tail of the data packet. The second CRC is generated based on the packet header and data_1. The first CRC is generated based on the packet header and the data, or is generated based on the packet header, the second CRC, and the data. Based on this implementation, a length (referred to as a preset length below) may be preset, and an insertion location of the second CRC (namely, a start location of the second CRC, referred to as a first location below) is a start location of the packet header+the preset length. For example, the preset length is greater than or equal to a first length, and the first length may be a largest length of various known packet header lengths. In this way, it can be ensured that the second CRC can be inserted after the packet header, and the second CRC is not inserted into the packet header, so that integrity of the packet header can be ensured. It should be noted that, because packet header lengths of different data packets may be different, for different data packets, bit sizes of data_1 before the second CRC may be different. For example, if the preset length is 100 bits, and a packet header of a data packet x is 60 bits, a bit size of data_1 in the data packet x is 40 bits. If a packet header of a data packet y is 70 bits, a bit size of data_1 in the data packet y is 30 bits.

Step 202: The first device sends the data packet to the second device. Correspondingly, the second device receives the data packet.

The first device may send the data packet to the second device through the interface between the first device and the second device. Alternatively, the first device sends the data packet to the second device through forwarding performed by one or more third-party devices.

Step 203: The second device checks the data packet based on the first CRC in the data packet.

For example, after receiving the data packet, the second device obtains the first CRC in the data packet, and generates third CRC based on a part (for example, the packet header, the second CRC, and the data) other than the first CRC in the data packet.

If the first CRC is the same as the third CRC, check on the data packet succeeds, and it indicates that no error occurs during transmission of the data packet.

If the first CRC is different from the third CRC, check on the data packet fails, and it indicates that an error occurs during transmission of the data packet. A location in which the error occurs may be the packet header, the second CRC, the data, or the first CRC.

Step 204: The second device checks the packet header of the data packet based on the second CRC in the data packet.

The second device obtains the second CRC in the data packet, and generates fourth CRC based on a part that is in the data packet and that is located before the second CRC. The part located before the second CRC may be the packet header. For example, refer to the example in FIG. 3(a). Alternatively, the part located before the second CRC may be the packet header and data_1. For example, refer to the example in FIG. 3(b).

If the second CRC is the same as the fourth CRC, check on the packet header of the data packet succeeds, and it indicates that no error occurs during transmission of the packet header of the data packet.

If the second CRC is different from the fourth CRC, check on the packet header of the data packet fails, and it indicates that an error occurs during transmission of the packet header of the data packet. For the example in FIG. 3(a), if the second CRC is different from the fourth CRC, it indicates that check on the packet header of the data packet fails, in other words, there is a bit with a transmission error in the packet header. For the example in FIG. 3(b), if the second CRC is different from the fourth CRC, there may be a bit with a transmission error in the packet header, or there may be a bit with a transmission error in data_1. However, during actual application, generally, a proportion of data_1 in the data is very small. Therefore, for the example in FIG. 3(b), if the second CRC is different from the fourth CRC, it indicates that an error occurs in the packet header or data_1. Alternatively, no distinguishing may be performed, and it is uniformly considered that check on the packet header of the data packet fails, in other words, it is considered that there is a bit with a transmission error in the packet header.

Step 205: The second device processes the data packet based on a check result of the data packet and/or a check result of the packet header.

The following describes two different specific implementations of step 203 to step 205.

Implementation 1: The second device not only performs step 203 to obtain the check result of the data packet, but also performs step 204 to obtain the check result of the packet header, and processes the data packet based on the check result of the data packet and/or the check result of the packet header.

An execution sequence of step 203 and step 204 is not limited. For example, step 203 may be performed before step 204, step 204 may be performed before step 203, or the two steps are performed concurrently in no particular order.

In the implementation 1, that the second device processes the data packet based on the check result of the data packet and/or the check result of the packet header may be specifically divided into the following case 1 and case 2.

Case 1: If check on the data packet succeeds, it indicates that no error occurs during transmission of the data packet. In this case, the second device does not discard the data packet. The "not discard" in this embodiment of this application may be, for example, storing, reserving, continuing processing, or transmitting the data packet to a next-level data processing module for subsequent processing. The "discard" in this embodiment of this application may include deleting, overwriting by other data, no further processing, or not transmitting the data packet to a next-level data processing module. Descriptions are uniformly provided herein, and details are not described below again. Optionally, if the second CRC is located in the data, the second device may obtain the data in the data packet after deleting the second CRC. For example, refer to FIG. 3(b). After deleting the second CRC, the second device may obtain the data in the data packet based on data_1 and data_2.

If check on the data packet succeeds, it means that no transmission error occurs in the packet header and the data. Therefore, it may be considered that check on the packet header also succeeds. Therefore, if check on the data packet succeeds, it may indicate that check on the data packet succeeds and check on the packet header succeeds.

Case 2: If check on the data packet fails, it indicates that an error occurs during transmission of the data packet. A location in which the error occurs may be the packet header, the second CRC, the data, or the first CRC. In this case, the second device may alternatively not discard the data packet. Instead, the second device may determine, based on the check result of the packet header, how to process the data packet. Therefore, the case 2 may be further divided into the following case 2.1 and case 2.2.

Case 2.1: If check on the data packet fails but check on the packet header of the data packet succeeds, it indicates that a transmission error occurs in the data packet, but a location in which the error occurs is not the packet header, in other words, no transmission error occurs in the packet header. This case may be understood as that a transmission error occurs in the data in the data packet. In this case, the second device may process the data packet based on the type of the data packet. The example of FIG. 3(a) means that a transmission error occurs in the data and/or the first CRC. The example of FIG. 3(b) means that a transmission error occurs in data_2 in the data and/or the first CRC.

The second device may determine the type of the data packet based on the packet header. For example, the packet header may include the type of the data packet, or include indication information indicating the type of the data packet, or the packet header may correspond to the type of the data packet.

In an implementation, that the second device processes the data packet based on the type of the data packet may be, for example, the following: if the type of the data packet is the user plane data, skipping discarding the data packet; or if the type of the data packet is the control plane data, discarding the data packet.

Specifically, if the type of the data packet is the user plane data, it means that the packet header of the data packet is correctly transmitted, a transmission error occurs in the data in the data packet, and the data includes the user plane data or all of the data is the user plane data. In this case, although some errors occur in the transmitted user plane data, the user plane data can be correctly processed because the packet header is correctly transmitted. In addition, the error in the user plane data may slightly affect user experience, and actually does not cause other more serious impact. Therefore, the second device may not discard the data packet. This manner can improve data transmission efficiency and increase a system capacity. Optionally, if the second CRC is located in the data, the second device may obtain the data in the data packet after deleting the second CRC. For example, refer to FIG. 3(b). After deleting the second CRC, the second device may obtain the data in the data packet based on data_1 and data_2. Optionally, after deleting the second CRC to obtain the data, the second device may perform next processing on the data or send the data to a next-level data processing module for subsequent processing.

If the type of the data packet is the control plane data, it means that the packet header of the data packet is correctly transmitted, a transmission error occurs in the data in the data packet, and the data is the control plane data. In this case, although the packet header is correctly transmitted, an error occurs in the transmitted control plane data. Because a consequence caused by the error in the control plane data is relatively serious, the second device discards the data packet.

Case 2.2: if check on the data packet fails and check on the packet header of the data packet fails, it indicates that a transmission error occurs in the data packet and a location in which the error occurs includes at least the packet header, that is, a transmission error occurs in the packet header. In this case, the second device may discard the data packet.

Because the packet header includes one or more of a source address, a destination address, a source port number, a destination port number, protocol information, and the like, the packet header takes a critical effect in how to correctly process the data packet by the second device. Therefore, if check on the packet header fails, the data packet is discarded.

Implementation 2: The second device first performs step 203 to obtain the check result of the data packet. If the check result of the data packet is that check on the data packet succeeds, the data packet is not discarded. For details, refer to the descriptions of the case 1 in the foregoing implementation 1, and step 204 and step 205 are not performed later. If the check result of the data packet is that check on the data packet fails, step 204 is performed again to obtain the check result of the packet header, and the data packet is processed based on the check result of the packet header. Processing the data packet based on the check result of the packet header includes two cases, which are respectively described as the case 2.1 and the case 2.2 in the foregoing implementation 1.

Based on the implementation 2, if check on the data packet succeeds, the packet header is not checked any more. Therefore, a quantity of check times can be reduced, thereby improving check efficiency.

Based on the implementation 2, optionally, if check on the data packet fails, the data packet may be marked. In other words, if check on the data packet fails, the data packet is not discarded. Instead, the data packet is marked. For example, the data packet may be marked by using a special character or a specific bit, to indicate that the data packet is a data packet that needs to be further determined. Subsequently, the packet header of the data packet is checked by using the second CRC again, and whether to discard the data packet or not to discard the data packet is determined based on the check result of the packet header.

In an implementation, in any one of the foregoing implementations, if the second device discards the received data packet, after discarding the data packet, the second device may further notify the first device to retransmit the data packet, to ensure the data packet to be correctly received, and improve user experience.

According to the foregoing solution, the second device includes, in the data packet, the first CRC used to check the data packet and the second CRC used to check the packet header of the data packet. When check on the data packet fails but check on the packet header succeeds, it indicates that the packet header is correctly transmitted, but the data is incorrectly transmitted. In this case, the second device may process the data packet based on the type of the data packet, instead of directly discarding the data packet. In this way, a quantity of packet losses can be reduced, thereby improving data transmission efficiency and increasing a system capacity.

The foregoing solution provided in this embodiment of this application may be applied to various scenarios. This is not limited in this application. The following provides descriptions with reference to a specific application scenario.

In the following example, that an interface between a first device and a second device is an eCPRI is used as an example for description. In this example, a data packet sent by the first device to the second device may be referred to as an eCPRI data packet, and data in the data packet may be referred to as eCPRI data.

Currently, on a conventional CPRI, transmitted data is actually a digital sampling signal of air interface data. A few of bit errors only affect numerical precision of the sampled data, and do not affect other samples. Therefore, a CPRI link has a high tolerance for a bit error of an optical fiber. After wireless fronthaul is switched from the CPRI to the eCPRI, there is a bit error on a fronthaul link, and according to a current processing mechanism, one bit error causes a CRC check failure of one data packet. Therefore, the data packet is discarded. However, discarding of one data packet causes an entire service packet to be discarded because not all data packets can be received. Therefore, a data loss caused by a bit error greatly magnified. Consequently, service performance is relatively reduced after the wireless fronthaul is switched from the CPRI to the eCPRI, and this affects user experience.

FIG. 4(a) is a schematic diagram of a format of an existing eCPRI-based service packet. One service packet includes one or more data packets, and each data packet includes a medium access control (medium access control, MAC) header, MAC data, and CRC.

The MAC header includes information such as a source MAC address and a destination MAC address.

The MAC data includes an eCPRI type and eCPRI data. The eCPRI data includes to-be-transmitted user plane data or control plane data.

The CRC is used to check correctness of the MAC header and the MAC data. If check on the CRC performed by the receiving end succeeds, it indicates that both the MAC header and the MAC data are transmitted correctly, and there is no error bit. If check on the CRC fails, it indicates that there is an incorrect bit in the MAC header and the MAC data.

FIG. 4(a) is used as an example. Assuming that a transmission error occurs in a bit or some bits in a data packet 3, check on CRC of the service data packet 3 performed by the receiving end fails. In this case, the receiving end discards the data packet 3 according to a current processing mechanism. In addition, because the receiving end fails to correctly receive the data packet 3, an entire service packet is also discarded because not all data packets can be received. This means that even if the receiving end correctly receives n-1 data packets other than the data packet 3, the receiving end discards the n-1 data packets. Consequently, service performance is relatively reduced, and user experience is affected.

The existing eCPRI data packet is improved in the following with reference to the method shown in FIG. 2. Specifically, an eCPRI data packet generated by a first device includes two pieces of CRC: first CRC and second CRC. Then, the first device sends the eCPRI data packet to a second device. The second device may determine, based on the first CRC and the second CRC in the eCPRI data packet, a manner for processing the eCPRI data packet.

A transmission and processing process of the eCPRI data packet includes the following steps.

Step 1: The first device obtains a data packet a, where the data packet a includes a MAC header, an eCPRI type, and eCPRI data.

The MAC header herein is a specific example of the packet header in the embodiment in FIG. 2.

A combination of the eCPRI type and the eCPRI data herein is a specific example of the data in the embodiment in FIG. 2.

Step 2: The first device inserts CRC 1 into the data packet a to obtain a data packet b.

The CRC 1 herein is a specific example of the second CRC in the embodiment in FIG. 2.

FIG. 4(b) is a schematic diagram of inserting CRC into a service data packet. In this example, the CRC 1 is inserted at a first location. After the CRC 1 is inserted, the eCPRI data is divided into eCPRI data_1 and eCPRI data_2. The CRC 1 is generated based on the MAC header, the eCPRI type, and eCPRI data_1. A combination of the eCPRI type and eCPRI data_1 herein is a specific example of data_1 in the embodiment in FIG. 2.

Step 3: The first device inserts CRC 2 into a tail of the data packet b to obtain a data packet c.

The CRC 2 header herein is a specific example of the first CRC in the embodiment in FIG. 2.

The CRC 2 is generated based on the MAC header, the eCPRI type, the CRC 1, eCPRI data_1, and eCPRI data_2.

Step 4: The first device sends the data packet c to the second device.

The data packet c herein is a specific example of the data packet sent by the first device to the second device in the embodiment in FIG. 2.

Step 5: The second device checks the CRC 2 in the data packet c, and optionally, further checks the CRC 1. This is divided into the following case 1 and case 2.

Case 1: If check on the CRC 2 succeeds, it indicates that the MAC header, the eCPRI type, and the eCPRI data are all correctly transmitted. In this case, the second device does not discard the data packet c. Optionally, the second device further deletes the CRC 1 to obtain the eCPRI data, and stores the eCPRI data.

Case 2: If check on the CRC 2 fails, the CRC 1 is further checked. This is divided into the following case 2.1 and case 2.2.

Case 2.1: If check on the CRC 1 fails, the data packet c is discarded.

Case 2.2: If check on the CRC 1 succeeds, the following case 2.2.1 and case 2.2.2 may be divided.

Case 2.2.1: If a type of the eCPRI data is user plane data, the data packet c is not discarded. Optionally, the second device further deletes the CRC 1 to obtain the eCPRI data.

Case 2.2.2: If a type of the eCPRI data is control plane data, the data packet c is discarded.

The second device may determine the type of the eCPRI data based on the MAC header and/or the eCPRI type.

According to the foregoing method, transmission and processing of the eCPRI data packet are implemented, so that data transmission efficiency can be improved and a system capacity can be increased, thereby helping improve user experience.

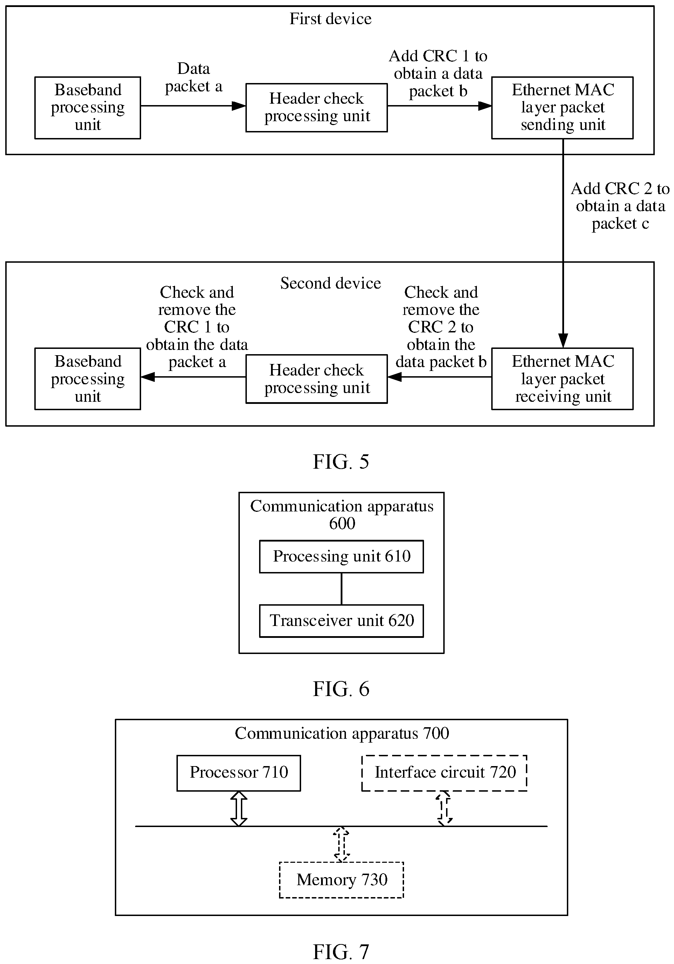

For example, the following provides an implementation of the first device and the second device. FIG. 5 is a schematic diagram of structures of a first device and a second device according to an embodiment of this application. Descriptions are provided below by using an example in which the first device and the second device shown in FIG. 5 are applied to a transmission and processing process of the foregoing eCPRI data packet.

The first device includes a baseband processing unit, a header check coding unit, and an Ethernet MAC layer packet sending unit.
(1) The baseband processing unit generates a data packet a, where the data packet a includes a MAC header, an eCPRI type, and eCPRI data.
(2) The header check processing unit generates CRC 1 based on the MAC header, the eCPRI type, and eCPRI data_1, and inserts the CRC 1 at a first location to obtain a data packet b.
(3) The Ethernet MAC layer packet sending unit generates CRC 2 based on the MAC header, the eCPRI type, the CRC 1, and the eCPRI data, adds the CRC 2 to a tail of the data packet b to obtain a data packet c, and sends the data packet c to the second device through an eCPRI interface between the first device and the second device.

The second device includes an Ethernet MAC layer packet receiving unit, a header check decoding unit, and a baseband processing unit.
(1) The Ethernet MAC layer packet receiving unit receives the data packet c, and checks the CRC 2 in the data packet c. If check on the CRC 2 succeeds, the Ethernet MAC layer packet receiving unit deletes the CRC 2 in the data packet c to obtain the data packet b, and generates mark information 1. The mark information 1 indicates that check on the data packet succeeds. Then, the Ethernet MAC layer packet receiving unit sends the data packet b and the mark information 1 to a header check unit. If check on the CRC 2 fails, the Ethernet MAC layer packet receiving unit deletes the CRC 2 to obtain the data packet b, and generates mark information 2. The mark information 2 indicates that check on the data packet fails. Then, the Ethernet MAC layer packet receiving unit sends the data packet b and the mark information 2 to a header check unit.
(2) The header check processing unit receives the data packet b, and receives the mark information 1 or the mark information 2. If receiving the data packet b and the mark information 1, the header check processing unit removes the CRC 1 to obtain the data packet a, and generates mark information 3. The mark information 3 indicates that check on the data packet succeeds. Then, the header check processing unit sends the data packet a and the mark information 3 to the baseband processing unit. If receiving the data packet b and the mark information 2, the header check processing unit checks the CRC 1 in the data packet b. If check on the CRC 1 succeeds and a type of the data packet b is user plane data, the header check processing unit deletes the CRC 1 to obtain the data packet a, and generates mark information 3. The mark information 3 indicates that check on the data packet succeeds. Then, the header check processing unit sends the data packet a and the mark information 3 to the baseband processing unit. If check on the CRC 1 succeeds and a type of the data packet b is control plane data, or check on the CRC 1 fails, the header check processing unit deletes the CRC 1 to obtain the data packet a, and generates mark information 4. The mark information 4 indicates that check on the data packet fails. Then, the header check processing unit sends the data packet a and the mark information 4 to the baseband processing unit.
(3) The baseband processing unit receives the data packet a, and receives the mark information 3 or the mark information 4. If receiving the data packet a and the mark information 3, the baseband processing unit does not discard the data packet a. For example, the baseband processing unit may process the data packet a or send the data packet a to a next-level data processing model for processing. If receiving the data packet a and the mark information 4, the baseband processing unit discards the data packet a.

In the foregoing implementation, the mark information 1, the mark information 2, the mark information 3, and the mark information 4 may not exist simultaneously. In the foregoing provided implementation, the Ethernet MAC layer packet receiving unit of the second device notifies, by using the mark information 1, the header check unit that check on the data packet succeeds, and notifies, by using the mark information 2, the header check unit that check on the data packet fails. In another implementation, when determining that check on the data packet c succeeds, the Ethernet MAC layer packet receiving unit sends the data packet b and one piece of mark information to the header check unit. When determining that check on the data packet c fails, the Ethernet MAC layer packet receiving unit sends the data packet b to the header check unit. Therefore, when receiving the data packet b and one piece of mark information, the header check unit determines that check on the data packet b succeeds, in other words, no transmission error occurs in the data packet b. When receiving the data packet b, the header check unit determines that check on the data packet b fails, in other words, a transmission error occurs in the data packet b. Alternatively, when determining that check on the data packet c succeeds, the Ethernet MAC layer packet receiving unit sends the data packet b to the header check unit. When determining that check on the data packet c fails, the Ethernet MAC layer packet receiving unit sends the data packet b and one piece of mark information to the header check unit.

In an implementation, the header check unit and the baseband processing unit may alternatively process the data packet in the following processing manner. The header check unit receives the data packet b, and receives the mark information 1 or the mark information 2. If receiving the data packet b and the mark information 1, the header check processing unit deletes the CRC 1 in the data packet b to obtain the data packet a, and sends the data packet a to the baseband processing unit. If receiving the data packet b and the mark information 2, the header check processing unit checks the CRC 1 in the data packet b. If check on the CRC 1 succeeds and the type of the data packet b is the user plane data, the header check processing unit deletes the CRC 1 to obtain the data packet a, and sends the data packet a to the baseband processing unit. If check on the CRC 1 succeeds and the type of the data packet b is the control plane data, or check on the CRC 1 fails, the header check processing unit discards the data packet b. Correspondingly, the baseband processing unit receives the data packet a, and the baseband processing unit does not discard the data packet a. For example, the baseband processing unit may process the data packet a or send the data packet a to a next-level data processing model for processing.

It may be understood that division and names of the foregoing functional units are merely examples, and functions implemented in a same unit in the foregoing example may alternatively be implemented by different functional modules or functional units. Similarly, functions implemented in different units in the foregoing examples may alternatively be implemented by a same functional module or unit according to requirements. This is not limited in this application.

According to the foregoing solution, most data packets that carry user plane data and that have error bits can be retrieved, and system performance in a bit error state of a fronthaul link can be improved.

It may be understood that, to implement the functions in the foregoing embodiments, the first device or the second device includes a corresponding hardware structure and/or a corresponding software module for executing each function. A person skilled in the art should be easily aware that, based on the units and the method steps in the examples described in embodiments disclosed in this application, this application can be implemented by hardware or a combination of hardware and computer software. Whether a function is performed by hardware or hardware driven by computer software depends on a particular application scenario and a design constraint of the technical solutions.

FIG. 6 and FIG. 7 are schematic diagrams of structures of possible communication apparatuses according to embodiments of this application. The communication apparatuses 600 may be configured to implement a function of the first device or the second device in the foregoing method embodiments. Therefore, the communication apparatuses may also implement beneficial effects of the foregoing method embodiments. In embodiments of this application, the communication apparatus may be the first device or the second device, or may be a module (for example, a chip) used in the first device or the second device. As shown in FIG. 6, the communication apparatus 600 includes a processing unit 610 and a transceiver unit 620. The communication apparatus 600 is configured to implement the function of the first device or the second device in the foregoing method embodiments. For example, when the communication apparatus 600 is configured to implement the function of the first device in FIG. 5, the processing unit 610 may be configured to implement functions of the baseband processing unit and the header check processing unit in the first device, and the transceiver unit 620 may be configured to implement a function of the Ethernet MAC layer packet sending unit in the first device. When the communication apparatus 600 is configured to implement the function of the second device in FIG. 5, the processing unit 610 may be configured to implement functions of the baseband processing unit and the header check processing unit in the second device, and the transceiver unit 620 may be configured to implement a function of the Ethernet MAC layer packet receiving unit in the second device.

In the first embodiment, the communication apparatus is configured to implement an operation of the second device in the method embodiment shown in FIG. 2. The transceiver unit 620 is configured to receive a data packet from the first device, where the data packet includes a packet header, data, first CRC, and second CRC. The processing unit 610 is configured to: check the data packet based on the first CRC in the data packet, check the packet header of the data packet based on the second CRC in the data packet, and process the data packet based on a check result of the data packet and/or a check result of the packet header.

In a possible implementation, the processing unit 610 is specifically configured to skip discarding the data packet if check on the data packet succeeds, or if check on the data packet succeeds and check on the packet header succeeds; discard the data packet if check on the data packet fails and check on the packet header fails; or process the data packet based on a type of the data packet if check on the data packet fails but check on the packet header succeeds.

In a possible implementation, the processing unit 610 is specifically configured to check the packet header of the data packet based on the second CRC in the data packet if check on the data packet fails.

In a possible implementation, the processing unit 610 is specifically configured to mark the data packet if check on the data packet fails.

In a possible implementation, the processing unit 610 is specifically configured to skip discard the data packet if the type of the data packet is user plane data; or discard the data packet if the type of the data packet is control plane data.

In a possible implementation, the processing unit 610 is further configured to determine the type of the data packet based on the packet header.

In a possible implementation, the processing unit 610 is further configured to delete the second CRC from the data packet.

In a possible implementation, the first CRC is located at a tail of the data packet, and the second CRC is located after the packet header of the data packet.

In a possible implementation, the first CRC is generated based on the packet header of the data packet and the data in the data packet.

In a possible implementation, the first CRC is generated based on the packet header of the data packet, the data in the data packet, and the second CRC.

In a possible implementation, the second CRC is generated based on the packet header of the data packet.

In a possible implementation, the second CRC is generated based on the packet header of the data packet and a part of the data in the data packet.

In a possible implementation, the data packet is an eCPRI data packet, and the data in the data packet includes eCPRI data.

In the second embodiment, the communication apparatus is configured to implement an operation of the first device in the method embodiment shown in FIG. 2. The processing unit 610 is configured to generate a data packet, where the data packet includes a packet header, data, first CRC, and second CRC, the first CRC is used to check the data packet, and the second CRC is used to check the packet header. The transceiver unit 620 is configured to send the data packet to the second device.

In a possible implementation, the processing unit 610 is further configured to generate the second CRC based on the packet header.

In a possible implementation, the processing unit 610 is specifically configured to generate the second CRC based on the packet header and a part of the data.

In a possible implementation, the processing unit 610 is further configured to generate the first CRC based on the packet header, the data, and the second CRC.

In a possible implementation, the first CRC is located at a tail of the data packet, and the second CRC is located after the packet header of the data packet.

In a possible implementation, the data packet is an eCPRI data packet, and the data in the data packet includes eCPRI data.

In a possible implementation, the packet header indicates a type of the data packet, and the type of the data packet is user plane data or control plane data.

For details about the processing unit 610 and the transceiver unit 620, directly refer to related descriptions in the foregoing method embodiments. Details are not described herein again.

As shown in FIG. 7, the communication apparatus 700 includes at least one processor 710, and may further include an interface circuit 720. The processor 710 and the interface circuit 720 may be coupled to each other. It may be understood that the interface circuit 720 may be a transceiver or an input/output interface. Optionally, the communication apparatus 700 may further include a memory 730, configured to store instructions executed by the processor 710, store input data required by the processor 710 to run the instructions, or store data generated after the processor 710 runs the instructions.

When the communication apparatus 700 is configured to implement the foregoing method embodiments, the processor 710 is configured to implement a function of the foregoing processing unit 610, and the interface circuit 720 may be configured to implement a function of the foregoing transceiver unit 620.

It may be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor.

The method steps in the embodiments of this application may be implemented in a hardware manner or may be implemented in a manner of executing software instructions by a processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a CD-ROM, or any other form of storage medium well-known in the art. For example, the storage medium is coupled to the processor, so that the processor can read information from the storage medium and write information into the storage medium. Certainly, the storage medium may alternatively be a component of the processor. The processor and the storage medium may be located in the ASIC. In addition, the ASIC may be located in a base station or a terminal. Certainly, the processor and the storage medium may alternatively exist in the base station or the terminal as discrete components.

All or some of the foregoing embodiments may be implemented by software, hardware, firmware, or any combination thereof. When software is used to implement the foregoing embodiments, all or some of the foregoing embodiments may be implemented in a form of a computer program product. The computer program product includes one or more computer programs or instructions. When the computer program or the instructions are loaded and executed on a computer, all or some of procedures or functions in embodiments of this application are performed. The computer may be a general-purpose computer, a dedicated computer, a computer network, a base station, user equipment, or another programmable apparatus. The computer program or the instructions may be stored in a computer-readable storage medium, or may be transmitted from a computer-readable storage medium to another computer-readable storage medium. For example, the computer program or the instructions may be transmitted from a website, computer, server, or data center to another website, computer, server, or data center in a wired or wireless manner. The computer-readable storage medium may be any usable medium accessible by the computer, or a data storage device, like a server or a data center, integrating one or more usable media. The usable medium may be a magnetic medium, for example, a floppy disk, a hard disk, or a magnetic tape; an optical medium, for example, a digital video disc; or a semiconductor medium, for example, a solid-state drive. The computer-readable storage medium may be a volatile or non-volatile storage medium, or may include both types of the volatile and non-volatile storage medium.

In various embodiments of this application, unless otherwise stated or there is a logic conflict, terms and/or descriptions between different embodiments are consistent and may be mutually referenced, and technical features in different embodiments may be combined based on an internal logical relationship thereof, to form a new embodiment.

In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. In the text descriptions of this application, the character "/" generally represents an "or" relationship between associated objects. In the formula of this application, the character "/" represents a "division" relationship between associated objects.

It may be understood that various numbers in embodiments of this application are merely used for differentiation for ease of description, and are not used to limit the scope of embodiments of this application. The sequence numbers of the foregoing processes do not mean execution sequences, and the execution sequences of the processes should be determined based on functions and internal logic of the processes.

## Claims

1. A data packet processing method, comprising:
receiving a data packet from a first device;
checking the data packet based on first cyclic redundancy check CRC in the data packet;
checking a packet header of the data packet based on second CRC in the data packet; and
if check on the data packet fails and check on the packet header fails, discarding the data packet; or
if check on the data packet fails but check on the packet header succeeds, processing the data packet based on a type of the data packet.

2. The method according to claim 1, wherein the checking a packet header of the data packet based on second CRC in the data packet comprises:
if check on the data packet fails, checking the packet header of the data packet based on the second CRC in the data packet.

3. The method according to claim 1 or 2, wherein the method further comprises:
if check on the data packet fails, marking the data packet.

4. The method according to any one of claims 1 to 3, wherein the processing the data packet based on a type of the data packet comprises:
if the type of the data packet is user plane data, skipping discarding the data packet; or
if the type of the data packet is control plane data, discarding the data packet.

5. The method according to claim 4, wherein the method further comprises:
determining the type of the data packet based on the packet header.

6. The method according to any one of claims 1 to 5, wherein the method further comprises:
deleting the second CRC from the data packet.

7. The method according to any one of claims 1 to 6, wherein the first CRC is located at a tail of the data packet, and the second CRC is located after the packet header of the data packet.

8. The method according to any one of claims 1 to 7, wherein the first CRC is generated based on the packet header of the data packet, data in the data packet, and the second CRC.

9. The method according to any one of claims 1 to 8, wherein the second CRC is generated based on the packet header of the data packet.

10. The method according to claim 9, wherein the second CRC is generated based on the packet header of the data packet and a part of the data in the data packet.

11. The method according to any one of claims 1 to 10, wherein the data packet is an enhanced common public radio interface eCPRI data packet, and the data in the data packet comprises eCPRI data.

12. A data packet processing method, comprising:
generating a data packet, wherein the data packet comprises a packet header, data, first cyclic redundancy check CRC, and second CRC, the first CRC is used to check the data packet, and the second CRC is used to check the packet header; and
sending the data packet to a second device.

13. The method according to claim 12, wherein the method further comprises:
generating the second CRC based on the packet header.

14. The method according to claim 13, wherein the generating the second CRC based on the packet header comprises:
generating the second CRC based on the packet header and a part of the data.

15. The method according to any one of claims 12 to 14, wherein the method further comprises:
generating the first CRC based on the packet header, the data, and the second CRC.

16. The method according to any one of claims 12 to 15, wherein
the first CRC is located at a tail of the data packet, and the second CRC is located after the packet header.

17. The method according to any one of claims 12 to 16, wherein the data packet is an enhanced common public radio interface eCPRI data packet, and the data in the data packet comprises eCPRI data.

18. The method according to any one of claims 12 to 17, wherein the packet header indicates a type of the data packet, and the type of the data packet is user plane data or control plane data.

19. A communication apparatus, comprising a module, configured to perform the method according to any one of claims 1 to 11, or a module, configured to perform the method according to any one of claims 12 to 18.

20. A communication apparatus, comprising at least one processor, wherein the at least one processor is configured to be coupled to a memory, and read and execute instructions in the memory to implement the method according to any one of claims 1 to 11, or the method according to any one of claims 12 to 18.

21. A computer program product, comprising a computer program, wherein when the computer program is executed by a communication apparatus, the method according to any one of claims 1 to 18 is implemented.

22. A computer-readable storage medium, wherein the storage medium stores a computer program or instructions, and when the computer program or the instructions are executed by a communication apparatus, the method according to any one of claims 1 to 18 is implemented.

23. A communication system, comprising a second device, configured to perform the method according to any one of claims 1 to 11, and a first device, configured to perform the method according to any one of claims 12 to 18.
